# EUROPEAN PATENT APPLICATION

(11) **EP 3 849 280 A1**
(43) Date of publication of application: **14.07.2021**
(21) Application number: 20217987.5
(22) Date of filing: 31.12.2020
(51) Int. Cl.: H05B 45/20, H01L 25/075, H01L 33/50

(54) **DIMMING AND TONING LED LIGHT**

(30) Priority: 07.01.2020 CN 202020027954 U
(71) Applicant: Leedarson Lighting Co., Ltd., Zhangzhou, Fujian 363000 (CN)
(72) Inventor: CHEN, Yanbiao, Zhangzhou, Fujian 363000 (CN); LIN, Liping, Zhangzhou, Fujian 363000 (CN)
(74) Representative: Kuhnen & Wacker Patent- und Rechtsanwaltsbüro PartG mbB

(57) **Abstract**

The present application provides a dimming and toning LED light, comprising a light housing, a control circuit board and a LED light source assembly, the light housing forms an assembly space, the control circuit board is installed in the assembly space, the LED light source assembly is installed in the assembly space, the LED light source assembly comprises a light board and a first LED light source, the first LED light source is assembled on the light board, wherein the first LED light source comprises a first LED chip, a second LED chip, a first phosphor layer and a second phosphor layer, the first LED chip and the second LED chip are all electrically connected to the control circuit board to control and adjust the light output spectrum of the first LED chip and the second LED chip, the first phosphor layer covers the first LED chip, and the second phosphor layer covers the second LED chip and the first phosphor layer. The present technical solution aims to solve the problem that using many white light sources of different spectrums to illuminate and mix the light to obtain the white light with different color temperatures when the white light spectrum of different color temperatures needs to be continuously changed in the prior art, which is very inconvenient and expensive.

## Description

### TECHNICAL FIELD

The present application relates to the technical field of LED lighting, and particularly relates to a dimming and toning LED light.

### BACKGROUND

When the existing dimming and toning LED light is used for lighting, the color temperature of white light lighting is adjusted. One of the adjustment methods is to mix the white light of one spectrum color temperature and the white light of another spectrum into white light of other spectrums. Another method can also be used, that is to mix white light of one spectrum and colure light of red, green and blue spectrum into white light of other spectrums. That is to say, the color temperature adjustment for white light illumination in the prior art requires at least two different light sources to illuminate and then mix to obtain the white light spectrum of the target color temperature. Therefore, when the white light spectrum of different color temperatures needs to be continuously changed, it is necessary to use many white light sources of different spectrums to illuminate the light and then mix the lights to obtain white light of different color temperatures, which is very inconvenient and expensive.

### SUMMARY

The purpose of the present application is to provide a dimming and toning LED light, which aims to solve the problem that using many white light sources of different spectrums to illuminate and mix the light to obtain the white light with different color temperatures when the white light spectrum of different color temperatures needs to be continuously changed in the prior art, which is very inconvenient and expensive.

In order to achieve the above purpose, the present application adopts a technical solution: a dimming and toning LED light, comprising a light housing, the light housing forms an assembly space, and the dimming and toning LED light further comprises: a control circuit board installed in the assembly space, a LED light source assembly installed in the assembly space, the LED light source assembly comprises a light board and a first LED light source, the first LED light source is assembled on the light board, wherein the first LED light source comprises a first LED chip, a second LED chip, a first phosphor layer and a second phosphor layer, the first LED chip and the second LED chip are all electrically connected to the control circuit board to control and adjust the light output spectrum of the first LED chip and the second LED chip, the first phosphor layer covers the first LED chip, and the second phosphor layer covers the second LED chip and the first phosphor layer, and the wavelengths of light emitted by the excitation of the first phosphor layer and the second phosphor layer are different.

Furthermore, the wavelength of light emitted by the excitation of the first phosphor layer is greater than the wavelength of light emitted by the excitation of the second phosphor layer.

Furthermore, the first LED light source further comprises a blocking vertical plate for blocking the first phosphor layer, the blocking vertical plate is arranged on the light board, and the blocking vertical plate is located between the first LED chip and the second LED chip.

Furthermore, the first LED light source further comprises a first mounting slot shell, the first mounting slot shell is connected to the light board, the first mounting slot shell defines a mounting slot, the first LED chip, the second LED chip and the blocking vertical plate are all provided on the bottom of the mounting slot, the two ends of the blocking vertical plate are connected to the corresponding slot walls of the mounting slot, respectively.

Furthermore, the top height distance of the blocking vertical plate is smaller than the depth distance of the mounting slot of the first mounting slot shell.

Furthermore, the number of first LED light sources is at least two, and at least two first LED light sources are evenly distributed on the light board.

Furthermore, the dimming and toning LED light further comprises a second LED light source installed on the light board, and the second LED light source comprises a red light LED chip, a green light LED chip, a blue light LED chip and a scattering powder glue layer, the red light LED chip, the green light LED chip and the blue light LED chip are all electrically connected to the control circuit board to control and adjust the light output spectrum of the red light LED chip, the green light LED chip and the blue light LED chip, the scattering powder glue layer covers the red light LED chip, the green light LED chip and the blue light LED chip.

Furthermore, after exciting the first phosphor layer and the first LED chip excites the second phosphor layer to emit the first spectrum white light, the second LED chip excites the second phosphor layer to emit the second spectrum white light, and the first spectrum white light and the second spectrum white light are mixed to emit light as the target spectrum white light.

Furthermore, the control circuit board comprises: a rectifier module, used to rectify the input alternating current to obtain direct current and output the direct current; an IC control module, used to output pulse signals, the IC control module is electrically connected to the rectifier module for power-on operation, the IC control module and the first LED chip, second LED chip, red light LED chip, green light LED chip and blue light LED chip are electrically connected to output pulse current correspondingly; a pulse current output module, used to form and output pulse current, the pulse current output module is electrically connected to the rectifier module, and the pulse current output module is electrically connected to the IC control module to receive the pulse signal output by the IC control module to form a corresponding pulse current.

Furthermore, the number of second LED light sources is at least two, and at least two second LED light sources are evenly distributed on the light board.

The beneficial effects of the present application:
In the process of applying the dimming and toning LED light for illumination, the first LED chip emits light to excite the first phosphor layer to emit light, and then the first phosphor layer emits light to excite the second phosphor layer to emit the first illuminating light, and at the same time, the second LED chip emits light to excite the second phosphor layer to emit the second illuminating light, so that the first illuminating light and the second illuminating light emit the light at the same time to achieve mixing light. As the wavelengths of light emitted by excitation of the first phosphor layer and the second phosphor layer are different, after the first illuminating light and the second illuminating light are mixed, the target light of the required spectrum is formed, and the target light is transmitted out for illumination, so that the light dimming and toning is realized in the same lighting source to obtain the target light of the required color temperature, and then the light is directly emitted for illumination.

### BRIEF DESCRIPTION OF THE DRAWINGS

In order to more clearly describe the technical solution in the embodiments of the present application, the following will briefly introduce the drawings that need to be used in the embodiment or in the prior art description. Obviously, the drawings in the following description are only for some embodiments of the application, for those of ordinary skill in the art, other drawings can be obtained based on these drawings without creative labor.
Fig. 1 is a cross-sectional view of the dimming and toning LED light of the first embodiment of the present application;
Fig. 2 is a schematic diagram of the assembly between the first LED light source and the light board in the dimming and toning LED light of the first embodiment of the present application;
Fig. 3 is a cross-sectional view along the A-A direction of Fig. 2;
Fig. 4 is a schematic diagram of the second LED light source in the dimming and toning LED light of the second embodiment of the present application;
Fig. 5 is a cross-sectional view along the B-B direction of Fig. 4;
Fig. 6 is a schematic diagram of circuit connection of the dimming and toning LED light of the second embodiment of the present application;
Fig. 7 is a cross-sectional view of the assembly between the first LED light source and the light board in the dimming and toning LED light of the third embodiment of the present application;
Fig. 8 is a schematic diagram of the first LED light source in the dimming and toning LED light of the fourth embodiment of the present application;
Fig. 9 is a cross-sectional view along the C-C direction of Fig. 8;
Fig. 10 is a top view of the dimming and toning LED light of the fifth embodiment of the present application after the light-transmitting portion is removed.

Wherein, the reference in the figures:
10, Light housing; 11, Assembly space; 1 01, Light-transmitting portion; 102, Housing body; 20, Control circuit board; 21, Rectifier module; 22, IC control module; 23, Pulse current output module; 30, LED light source assembly; 31, Light board; 32, The first LED light source; 321, The first LED chip; 322, The second LED chip; 323, The first phosphor layer; 324, The second phosphor layer; 325, Blocking vertical plate ; 326, The first mounting slot shell; 33, The second LED light source; 331, Red light LED chip; 332, Green light LED chip; 333, Blue light LED chip; 334, Scattering powder glue layer; 335, The second mounting slot shell; 40, Radio frequency device.

### DETAILED DESCRIPTIONS

The embodiments of the present application are described in detail as below. Examples of the embodiments are shown in the accompanying drawings, wherein the same or similar reference numerals indicate the same or similar elements or elements with the same or similar functions. The embodiments described below with reference to the accompanying drawings are exemplary, and are intended to explain the present application, and cannot be understood as a limitation to the present application.

In the description of the present application, it should be understood that the orientation or positional relationship indicated by the terms of "length", "width", "upper", "lower", "front", "rear", "left", "right", "vertical", "horizontal", "top", "bottom", "inner", "outer", etc. are based on the orientation or positional relationship shown in the drawings, only for the convenience of describing the present application and simplifying the description. It does not indicate or imply that the pointed device or element must have a specific orientation, be constructed and operated in a specific orientation, and therefore cannot be understood as a limitation to the present application.

In addition, the terms of "first" and "second" are only used for descriptive purposes, and cannot be understood as indicating or implying relative importance or implicitly indicating the number of indicated technical features. Therefore, the features defined with "first" and "second" may explicitly or implicitly include one or more of these features. In the description of the present application, "a plurality of' means two or more, unless otherwise specifically defined.

In the present application, unless otherwise clearly specified and defined, the terms of "installation", "connected", "connecting", "fixed" and other terms should be understood in a broad sense, for example, it can be a fixed connection or a detachable connection or being integrated in one piece; it can be a mechanical connection or an electrical connection; it can be directly connected or indirectly connected through an intermediary, and it can be a connection between two components or an interaction relationship between two components. For those of ordinary skill in the art, the specific meaning of the above-mentioned terms in the present application can be understood according to specific circumstances.

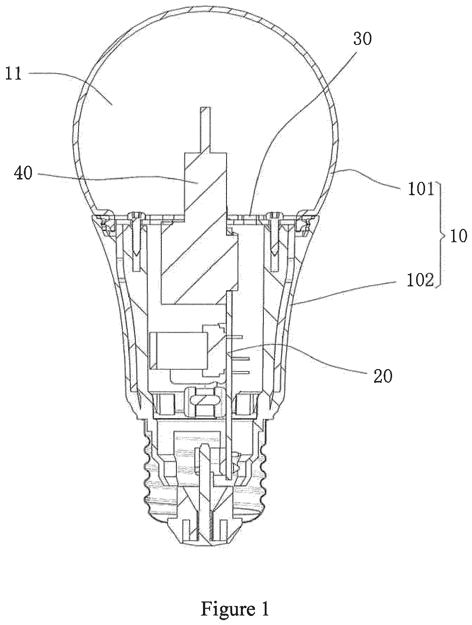

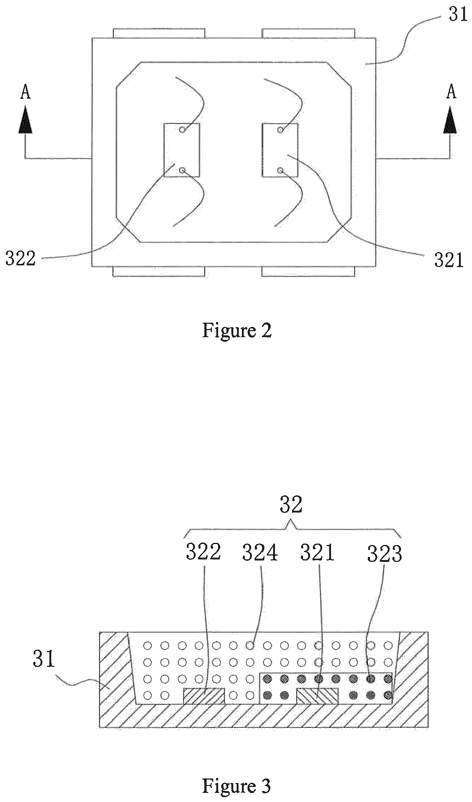

As shown in Figures 1 to 3, the dimming and toning LED light provided by the first embodiment of the present application includes a light housing 10, a control circuit board 20 and an LED light source assembly 30, and the LED light source assembly 30 includes a light board 31 and a first LED light source 32, the first LED light source 32 are assembled on the light board 31. The light housing 10 forms an assembly space 11. Specifically, the light housing 10 is composed of a light-transmitting portion 101 and a housing body 102. The light-transmitting portion 101 and the housing body 102 are connected to form an assembly space 11, the control circuit board 20 is installed in the assembly space 11, and the LED light source assembly 30 is installed in the assembly space 11, after the installation of the LED light source assembly 30 is completed, the emitted light is irradiated towards the light-transmitting portion 101 and emitted for illumination. The first LED light source 32 includes a first LED chip 321, a second LED chip 322, a first phosphor layer 323 and a second phosphor layer 324, the first LED chip 321 and the second LED chip322 are electrically connected to control circuit board 20 to control and adjust the light output spectrum of the first LED chip 321 and the second LED chip 322, the first LED chip 321 and the second LED chip 322 are arranged side by side, the first phosphor layer 323 covers the first LED chip 321, the second phosphor layer 324 covers the second LED chip 322 and the first phosphor layer 323, and the wavelengths of emitted light by excitation of the first phosphor layer 323 and the second phosphor layer 324 are different.

In the process of applying the dimming and toning LED light provided by the first embodiment for lighting, the control circuit board 20 is powered on to provide power to the first LED chip 321 and the second LED chip 322 of the LED light source assembly 30 to emit light, and the first LED chip 321 emits light to excite the first phosphor layer 323 to emit light, and then the first phosphor layer 323 emits light to excite the second phosphor layer 324 to emit the first illuminating light. At the same time, the second LED chip 322 emits light to excite the second phosphor layer 324 to emit the second illuminating light. In this way, the first illuminating light and the second illuminating light irradiate toward the light-transmitting portion 101 at the same time to achieve mixing. Since the wavelengths of emitted light by excitation of the first phosphor layer 323 and the second phosphor layer 324 are different, the first and second illuminating light are mixed to form the target light of the required spectrum. The target light is transmitted out for illumination from light-transmitting portion 101, so that the light dimming and toning is realized in the same illumination light source to obtain the target light of the desired color temperature, and then the light is directly emitted for illumination.

In addition, through the cooperation between the radio frequency device 40 and the control circuit board 20, the light emission of the first LED chip 321 and the second LED chip 322 is controlled, so that the first LED chip 321 and the second LED chip 322 can emit light of different spectral types according to the needs of use, and then, the first LED chip 321 sequentially excites the first phosphor layer 323 and the second phosphor layer 324 to obtain the first illuminating light of the required spectrum, and the second LED chip 322 excites the second phosphor layer 324 to obtain the second illuminating light of the required spectrum, so that the first illuminating light and the second illuminating light are mixed to obtain the target light that can be connected to the changing target spectrum, and the target light is emitted from the light-transmitting portion 101 for illumination.

Compared with the prior art that uses light sources with different spectrums to illuminate and emit light and then mixes the two lights to achieve light dimming and toning, the present application directly integrates dimming and toning LED chips in the same light source. By controlling the first LED chip 321 and the second LED chip 322 to emit continuous spectrum light, and then mixing, dimming and toning to obtain the target light of continuous spectrum, so as to realize the adjustment function of continuous spectrum adjustment and transformation, that is, the dimming and toning LED light of the present application itself can complete different spectrum adjustment and transformation, which is more convenient and cost-effective compared with the prior art.

When assembling the first phosphor layer 323 and the second phosphor layer 324 in the first embodiment, the edge of the first phosphor layer 323 covers the light board 31, and the edge of the second phosphor layer 324 covers the light board 31. While the first LED chip 321 excites the first phosphor layer 323 to emit light and irradiates the second phosphor layer 324 to excite light, the second LED chip 322 excites the second phosphor layer 324 to emit light, and the first and second illuminating light excited in the second phosphor layer 324 are mixed, dimmed and toned, and the first and second illuminating light are emitted from the second phosphor layer 324 as a whole, making the mixed coaxial light output better.

In the first embodiment, when the same incident light irradiates the first phosphor layer 323 and the second phosphor layer 324 to excite light, the wavelength of the first phosphor layer 323 is greater than the wavelength of the second phosphor layer 324. In this way, the first LED chip 321 excites the first phosphor layer 323 and the second phosphor layer 324 in sequence to obtain the first illumination light and the second LED chip 322 excites the second phosphor layer 324 to obtain the second illumination light, the spectrums of the first illuminating light and the second illuminating light are different. (The control circuit board 20 can make the first LED chip321 and second LED chip322 emit light of the same spectrum type to excite the corresponding phosphor layer, or make the first LED chip321 and second LED chip322 emit light of different spectrum types to excite the corresponding phosphor layer).

Preferably, after exciting the first phosphor layer 323, the first LED chip 321 excites the second phosphor layer 324 to emit the first spectrum white light, that is, the first illuminating light is the first spectrum white light, and the second LED chip 322 excites the second phosphor layer 324 to emit the second spectrum white light, that is, the second illuminating light is the second spectrum white light, the mixed light of the first spectrum white light and the second spectrum white light is the target spectrum white light, and the target spectrum white light is the target light obtained by mixing the first illuminating light and the second illuminating light. In addition, after exciting the first phosphor layer 323 and the first LED chip 321 excites the second phosphor layer 324 to emit the first-spectrum primary color light, such as red light, and the second LED chip 322 excites the second phosphor layer 324 to emit the second-spectrum primary color light, such as green light. In this way, when the red light and the green light are mixed, dimmed and toned, the yellow light of the target spectrum is obtained for illumination (at this time, the primary color light of the first spectrum and the primary color light of the second spectrum are two primary colors of the three primary colors, respectively).

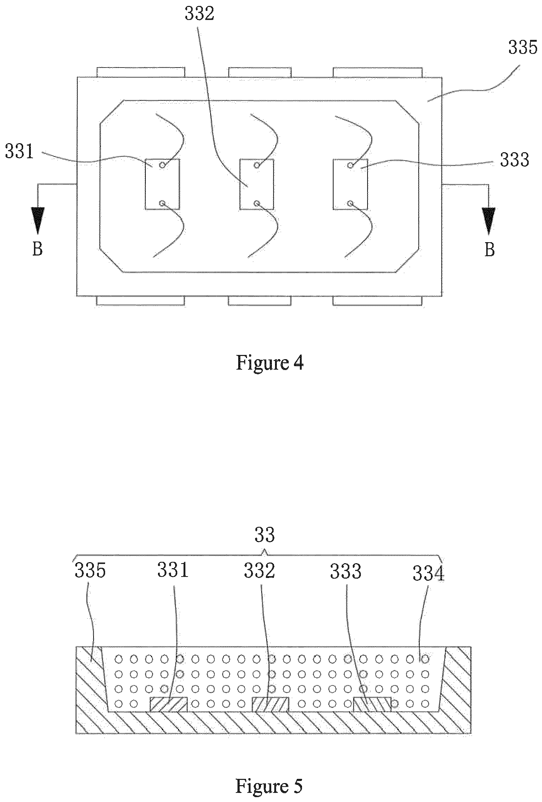

As shown in Figures 4 to 6, which show schematic diagrams of dimming and toning LED light in the second embodiment of the present application. Compared with the first embodiment, the dimming and toning LED light of the second embodiment has the following differences.

In the second embodiment, the first LED chip 321 excites the first phosphor layer 323 and then excites the second phosphor layer 324 to emit the first spectrum white light, and the second LED chip 322 excites the second phosphor layer 324 to emit the second spectrum white light. In addition, the dimming and toning LED light also includes a second LED light source 33, the second LED light source 33 and the first LED light source 32 are used independently, that is: when the first LED light source 32 is used for dimming and toning lighting, the second LED light source 33 does not perform luminous lighting; when the second LED light source33 is used for dimming and toning lighting, the first LED light source 32 does not perform luminous lighting at this time. Specifically, the second LED light source 33 is assembled on light board 31, the second LED light source 33 includes a red light LED chip331, a green light LED chip 332, a blue light LED chip 333 and a scattering powder glue layer 334, the red light LED chip 331, the green light LED chip 332 and the blue light LED chips 333 are all electrically connected to the control circuit board 20 to control and adjust the light emission spectrum of the red light LED chip 331, the green light LED chip 332 and the blue light LED chip 333. And the scattering powder glue layer 334 covers the red light LED chip 331, the green light LED chip 332 and the blue light LED chip 333. In the second embodiment, after the scattering powder glue layer 334 completely covers the red light LED chip 331, the green light LED chip 332, and the blue light LED chip 333, the edge of the scattering powder glue layer 334 covers the light board 31.

When the second LED light source33 is used for illumination, at this time, the red light, the green light, and the blue light of different spectra are emitted through the red light LED chip 331, the green light LED chip 332, and the blue light LED chip 333, and then the light of three primary colors are mixed, dimmed and toned to obtain the target light (white light) of the target spectrum for illumination. When you need to change the target spectrum of the target light, you only need to correspondingly control the red light LED chip 331, the green light LED chip 332, and the blue light LED chip 333 to emit the corresponding spectrum of red light, green light, and blue light to mix for dimming and toning. Then the target light of the required target spectrum can be obtained to achieve the purpose of transformation.

Correspondingly, the red light LED chip 331, the green light LED chip 332, and the blue light LED chip 333 are mixed to emit light through a unified scattering powder glue layer 334, which can better obtain the coaxial light of the mixed light.

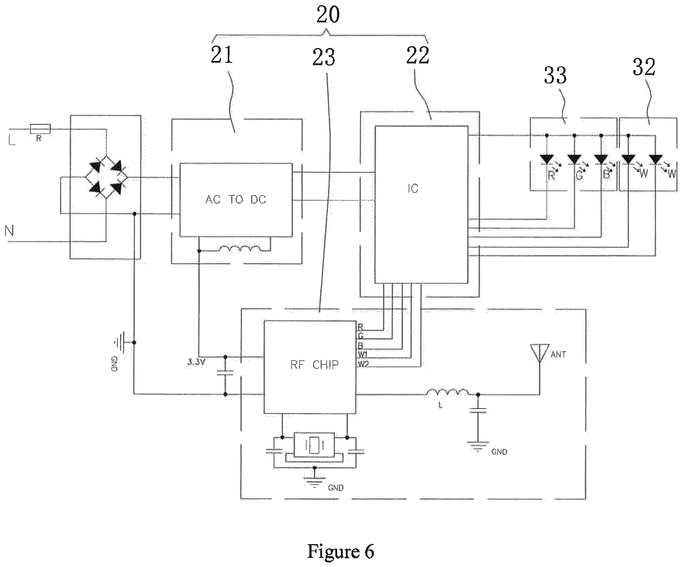

In the second embodiment, the control circuit board 20 includes a rectifier module 21, an IC control module 22 and a pulse current output module 23. The rectifier module 21 is used to rectify the input AC power to obtain and output DC power, the IC control module 22 is used to output pulse signals, and the IC control module 22 and the rectifier module 21 are electrically connected to power on, the IC control module 22 is electrically connected to the first LED chip 321, the second LED chip 322, the red light LED chip 331, the green light LED chip 332 and the blue light LED chip 333 to output pulse currents correspondingly, pulse current output module 23 is used to form and output pulse current, the pulse current output module 23 is electrically connected to the rectifier module 21, and the pulse current output module 23 is electrically connected to the IC control module 22 to receive the pulse signal output by the IC control module 22 to form a corresponding pulse current. As shown in Figure 6, where: R light-emitting diode represents the red light LED chip 331, G light-emitting diode represents the green light LED chip 332, B light-emitting diode represents the blue light LED chip 333, and two W light-emitting diodes represent the first LED chip 321 and the second LED chip 322, respectively. When the L and N terminals are connected to the home circuit of 220V, the rectifier module 21 converts AC to DC (AC TO DC), and the obtained DC is the function of the IC control module 22. In the working process, the radio frequency device 40 receives the control command sent by the control terminal and transmits the command to the IC control module 22. The IC control module 22 receives the command and analyzes the pulse signal command, and sends the pulse signal command to the pulse current output module 23 to control and form a corresponding pulse current, and the pulse current output module 23 transmits the formed pulse current for confirmation by the IC control module 22 and then is controlled and transmitted to the corresponding LED chip to emit light.

In the second embodiment, the second LED light source 33 uses the second mounting slot shell 335 to assemble the red light LED chip 331, the green light LED chip 332 and the blue light LED chip 333 to form a modular light source accessory, and then assembles and fixes the formed modular light source accessory on the light board 31, and solders the corresponding pins extending out of the second mounting slot shell 335 to complete the second LED light source 33 assembly.

Compared with the first embodiment, the second embodiment has the same structure except for the above structure, which will not be repeated here.

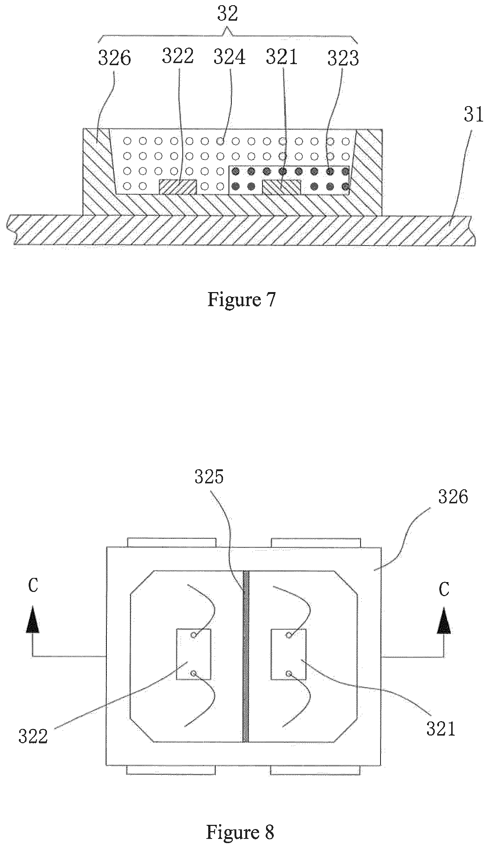

As shown in Figure 7, in the third embodiment of the present application, compared with the second embodiment, it has the following differences: the first LED light source 32 also includes a first mounting slot shell 326, the first mounting slot shell 326 is connected to the light board 31, the first mounting slot shell 326 defines a mounting slot. The first LED chip 321 and the second LED chip 322 are both arranged on the bottom of the mounting slot. The first phosphor layer 323 covers the first LED chip 321. And after the first phosphor layer 323 covers the first LED chip 321 completely, the edge of the first phosphor layer 323 covers the bottom of the mounting slot, the second phosphor layer 324 covers the second LED chip 322, and the second phosphor layer 324 also covers the first phosphor layer 323, and the mounting slot is filled by the second phosphor layer 324. The first LED chip 321 and the second LED chip 322 are installed through the first mounting slot shell 326, so that the first LED chip 321 and the second LED chip 322 can form a modular light source accessory, and then the formed modular light source accessory of the first LED chip 321 and the second LED chip 322 are assembled and fixed onto the light board 31, the corresponding pins extending out of the first mounting slot shell326 are soldered to complete the assembly.

Compared with the second embodiment, the third embodiment has the same structure except for the above structure, which will not be repeated here.

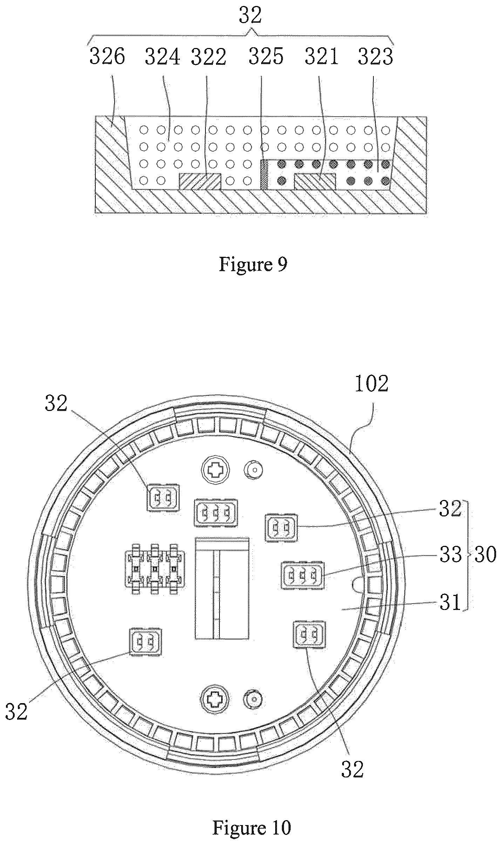

As shown in Figures 8 and 9, in the fourth embodiment of the present application, compared with the third embodiment, it has the following differences. In the fourth embodiment, the first LED light source 32 further includes a blocking vertical plate 325 for blocking the first phosphor layer 323, the blocking vertical plate 325 is arranged on the bottom of the mounting slot, and the blocking vertical plate 325 is located between the first LED chip 321 and the second LED the chip 322, and the two ends of the blocking vertical plate 325 are connected with the corresponding slot walls of the mounting slot, respectively. The first phosphor layer 323 is blocked by the blocking vertical plate 325, so that the coverage of the first phosphor layer 323 at the bottom of the first mounting slot shell 326 can be limited, so that the first phosphor layer 323 and the second phosphor layer 324 will not interfere with each other during the assembly process. At the same time, it can also ensure the purity of the second phosphor layer 324 covered by the second LED chip 322.

In the fourth embodiment, the top height distance of the blocking vertical plate 325 is smaller than the depth distance of the mounting slot of the first mounting slot shell 326. In this way, when the first LED chip321 excites the first phosphor layer 323 to emit light and irradiates the second phosphor layer 324 to excite light, the second LED chip 322 excites the second phosphor layer 324 to emit light, and the first and second illuminating light excited in the second phosphor layer 324 are mixed dimmed and toned and the first and second illuminating light is emitted from second phosphor layer 324 as a whole, which makes the mixed coaxial light output better.

Compared with the third embodiment, the fourth embodiment has the same structure except for the above structure, which will not be repeated here.

As shown in Figure 10, in the fifth embodiment of the present application, compared with the fourth embodiment, it has the following differences. In the fifth embodiment, the number of first LED light sources 32 is at least two, and at least two first LED light sources 32 are evenly distributed on the light board 31. In addition, the number of second LED light sources 33 is at least two, and at least two second LED light sources 33 are evenly distributed on the light board 31. Corresponding to some application scenarios that require high-intensity light for lighting, such as stage lighting, street lighting, etc., increase the number of first LED light source32 and second LED light source33 to achieve the purpose of high light intensity.

Compared with the fourth embodiment, the fifth embodiment has the same structure except for the above structure, which will not be repeated here.

The above are only the preferred embodiments of the present application, and are not used to limit the present application. Any modification, equivalent replacement and improvement made within the spirit and principle of the present application shall be included in the scope of protection of the present application.

## Claims

1. A dimming and toning LED light, comprising a light housing (10), the light housing (10) forms an assembly space (11), wherein the dimming and toning LED light further comprises:
a control circuit board (20) installed in the assembly space (11);
a LED light source assembly (30) installed in the assembly space (11), the LED light source assembly (30) comprises a light board (31) and a first LED light source (32), the first LED light source (32) is assembled on the light board (31), wherein the first LED light source (32) comprises a first LED chip (321), a second LED chip (322), a first phosphor layer (323) and a second phosphor layer (324), the first LED chip (321) and the second LED chip (322) are all electrically connected to the control circuit board (20) to control and adjust the light output spectrum of the first LED chip (321) and the second LED chip (322), the first phosphor layer (323) covers the first LED chip (321), and the second phosphor layer (324) covers the second LED chip (322) and the first phosphor layer (323), and the wavelengths of light emitted by the excitation of the first phosphor layer (323) and the second phosphor layer (324) are different.

2. The dimming and toning LED light according to claim 1, wherein the wavelength of light emitted by the excitation of the first phosphor layer (323) is greater than the wavelength of light emitted by the excitation of the second phosphor layer (324).

3. The dimming and toning LED light according to claim 1, wherein the first LED light source (32) further comprises a blocking vertical plate (325) for blocking the first phosphor layer (323), the blocking vertical plate (325)is arranged on the light board (31), and the blocking vertical plate (325)is located between the first LED chip (321) and the second LED chip (322).

4. The dimming and toning LED light according to claim 3, wherein the first LED light source (32) further comprises a first mounting slot shell (326), the first mounting slot shell (326) is connected to the light board (31), the first mounting slot shell (326) defines a mounting slot, the first LED chip (321), the second LED chip (322) and the blocking vertical plate (325) are all provided on the bottom of the mounting slot, the two ends of the blocking vertical plate (325) are connected to the corresponding slot walls of the mounting slot, respectively.

5. The dimming and toning LED light according to claim 4, wherein the top height distance of the blocking vertical plate (325) is smaller than the depth distance of the mounting slot of the first mounting slot shell (326).

6. The dimming and toning LED light according to any one of claims 1-5, wherein the number of first LED light source (32) is at least two, and at least two first LED light source (32) are evenly distributed on the light board (31).

7. The dimming and toning LED light according to any one of claims 1-5, wherein the dimming and toning LED light further comprises a second LED light source (33) installed on the light board (31), and the second LED light source (33) comprises a red light LED chip (331), a green light LED chip (332), a blue light LED chip (333) and a scattering powder glue layer (334), the red light LED chip (331), the green light LED chip (332) and the blue light LED chip (333) are all electrically connected to the control circuit board (20) to control and adjust the light output spectrum of the red light LED chip (331), the green light LED chip (332) and the blue light LED chip (333), the scattering powder glue layer (334) covers the red light LED chip (331), the green light LED chip (332) and the blue light LED chip (333).

8. The dimming and toning LED light according to claim 7, wherein after exciting the first phosphor layer (323) and the first LED chip (321) excites the second phosphor layer (324) to emit the first spectrum white light, the second LED chip (322) excites the second phosphor layer (324) to emit the second spectrum white light, and the first spectrum white light and the second spectrum white light are mixed to emit light as the target spectrum white light.

9. The dimming and toning LED light according to claim 8, wherein the control circuit board (20) comprises:
a rectifier module (21), used to rectify the input alternating current to obtain direct current and output the direct current;
an IC control module (22), used to output pulse signals, the IC control module (22) is electrically connected to the rectifier module (21) for power-on operation, the IC control module (22) and the first LED chip (321), second LED chip (322), red light LED chip (331), green light LED chip (332) and blue light LED chip (333) are electrically connected to output pulse current correspondingly;
a pulse current output module (23), used to form and output pulse current, the pulse current output module (23) is electrically connected to the rectifier module (21), and the pulse current output module (23) is electrically connected to the IC control module (22) to receive the pulse signal output by the IC control module (22) to form a corresponding pulse current.

10. The dimming and toning LED light according to claim 8, wherein the number of second LED light source (33) is at least two, and at least two second LED light source (33) are evenly distributed on the light board (31).
